# FASCICULE DE BREVET EUROPEEN

(11) **EP 0 406 798 B1**
(45) Date de publication et mention de la délivrance du brevet: **14.09.1994**
(21) Numéro de dépôt: 90112676.3
(22) Date de dépôt: 03.07.1990
(51) Int. Cl.: H01L 39/24

(54) **Conducteur supraconducteur à brins multiples transposés à canaux internes de refroidissement, et son procédé de fabrication**
Supraleiter mit einer Vielzahl von umgesetzten Fasern und mit inneren Kühlkanälen und Verfahren zu dessen Herstellung
Superconductor with multiple transposed filaments with internal cooling channels and method for making the same

(30) Priorité: 04.07.1989 FR 8908977
(43) Date de publication de la demande: 09.01.1991
(73) Titulaire: GEC ALSTHOM SA, 75116 Paris (FR)
(72) Inventeur: Bencharab, Christian, F-90400 Danjoutin (FR); Bonnet, Patrick, F-90300 Cravanche (FR); Nithart, Henri, F-90000 Belfort (FR)
(74) Mandataire: Weinmiller, Jürgen

(56) Documents cités:
- CH-A- 455 958
- IEEE TRANSACTIONS ON MAGNETICS, vol. 11, no. 2, mars 1975, New York, US, pp. 328-331 ; C.R. Walters: "Magnetization and design of multistrand superconducting conductors"

## Description

La présente invention concerne un conducteur supraconducteur à brins multiples transposés avec canaux internes de refroidissement.

On a déjà fabriqué des conducteurs supraconducteurs à brins multiples transposés de section droite rectangulaire ou trapézoïdale, présentant une bonne cohésion mécanique, permettant leur manipulation et notamment leur cintrage sur chant, nécessaires notamment dans le cas de leur utilisation dans la fabrication de bobinage d'aimants, etc...en étamant l'ensemble des brins assemblés avec transposition dans un bain d'étain ou d'alliage d'étain. Mais leur refroidissement par un fluide cryogénique est difficile dès que leur section droite devient importante, car ce fluide ne peut venir en contact qu'avec la surface externe du conducteur supraconducteur, et il apparaît un gradient de température importante entre la surface et le coeur de ce dernier. On ne peut donc les former que par assemblage d'un nombre réduit de brins, afin de maintenir un refroidissement acceptable.

La présente invention a pour but de procurer un conducteur supraconducteur à brins multiples transposés présentant une bonne cohésion mécanique, facilement manipulable même avec un nombre important de brins, mais bien refroidissable par un fluide cryogénique, et un procédé simple de fabrication d'un tel conducteur supraconducteur.

Le conducteur supraconducteur selon l'invention est caractérisé en ce qu'il se compose d'une première fraction de brins étamés et d'une fraction complémentaire de brins non étamés, les brins de la première fraction et de la fraction complémentaire étant régulièrement alternés, dans lequel leur assemblage avec transposition est assuré par des adhérences sensiblement ponctuelles entre les brins étamés, laissant ainsi subsister à l'intérieur du conducteur supraconducteur des canaux pour la circulation d'un fluide réfrigérant.

Il comporte de préférence une moitié de brins étamés.

Le procédé de fabrication selon l'invention est caractérisé en ce que l'on étame individuellement une fraction, et de préférence la moitié, des brins destinés à former le conducteur supraconducteur, en ce que l'on assemble avec transposition les brins étamés et les brins non étamés en une structure où ils sont régulièrement alternés, en ce que l'on soumet la structure ainsi formée à un chauffage assurant la fusion de la couche d'étain des brins étamés, puis en ce que l'on laisse l'ensemble faire prise par refroidissement en une structure munie de canaux délimités par des brins préalablement étamés et des brins non préalablement étamés.

L'on étame la première fraction des brins de préférence de manière qu'ils soient recouverts d'une couche d'étain ou d'alliage d'étain de quelques micromètres, de sorte qu'après fusion de l'étain il subsiste entre les brins des canaux.

Il est décrit ci-après à titre d'exemple et en référence aux figures schématiques de dessin annexé, un conducteur supraconducteur selon l'invention et son procédé de fabrication.

La figure 1 représente en perspective à échelle agrandie une fraction d'un conducteur supraconducteur avant traitement thermique de fusion de la couche d'étain des brins étamés.

La figure 2 représente en élévation la surface interne du supraconducteur, après ce traitement thermique.

Les figures 3 et 4 représentent en perspective une ligne d'étamage de brins individuels et une ligne d'assemblage des brins en un supraconducteur, suivi de l'agglomération par fusion de la couche d'étain.

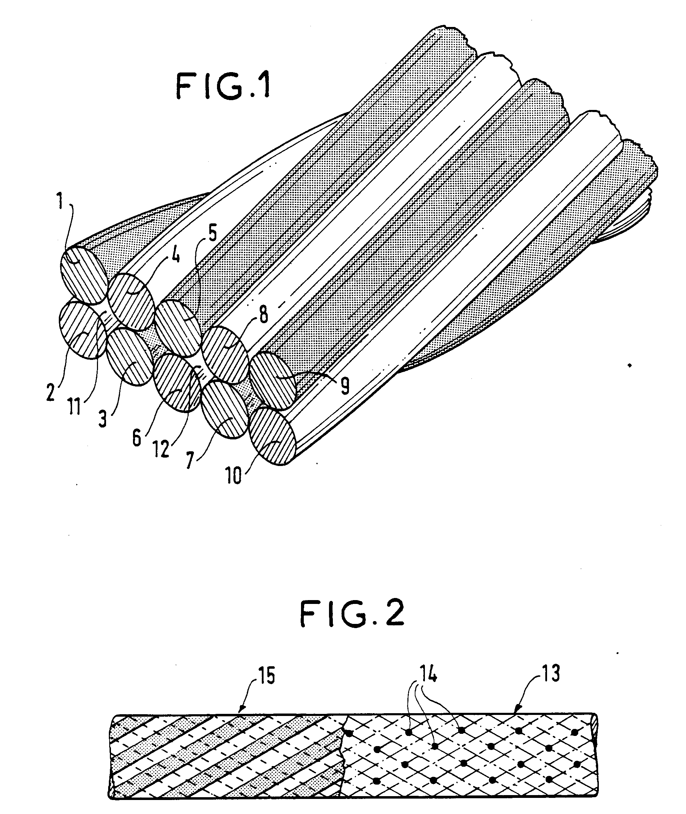

Dans la figure 1, le supraconducteur comprend des brins préalablement étamés 1, 3, 5, 7, 9 recouverts d'une couche d'étain ou d'alliage d'étain de quelques micromètres, et des brins nus non étamés 2, 4, 6, 8, 10, l'ensemble des brins étant assemblé avec transposition de manière qu'un brin étamé soit disposé dans chaque couche entre deux brins nus et réciproquement. On voit que lors du traitement thermique ultérieur la couche d'étain des brins préalablement étamés va fondre et réunir ponctuellement ces brins, en laissant subsister entre les brins étamés et non étamés des canaux tels que 11, 12. Après refroidissement et solidification de l'étain, tous les brins seront solidarisés, en laissant subsister entre eux des canaux tels que 11, 12.

Le supraconducteur ainsi formé présentera la cohésion requise pour ses manipulations ultérieures, notamment des cintrages sur chant, tout en comportant des canaux permettant le passage d'un fluide cryogénique de refroidissement.

La partie droite 13 de la figure 2 représente schématiquement les points 14 de collage entre eux des brins du câble, et sa partie gauche 15 la disposition des brins transposés.

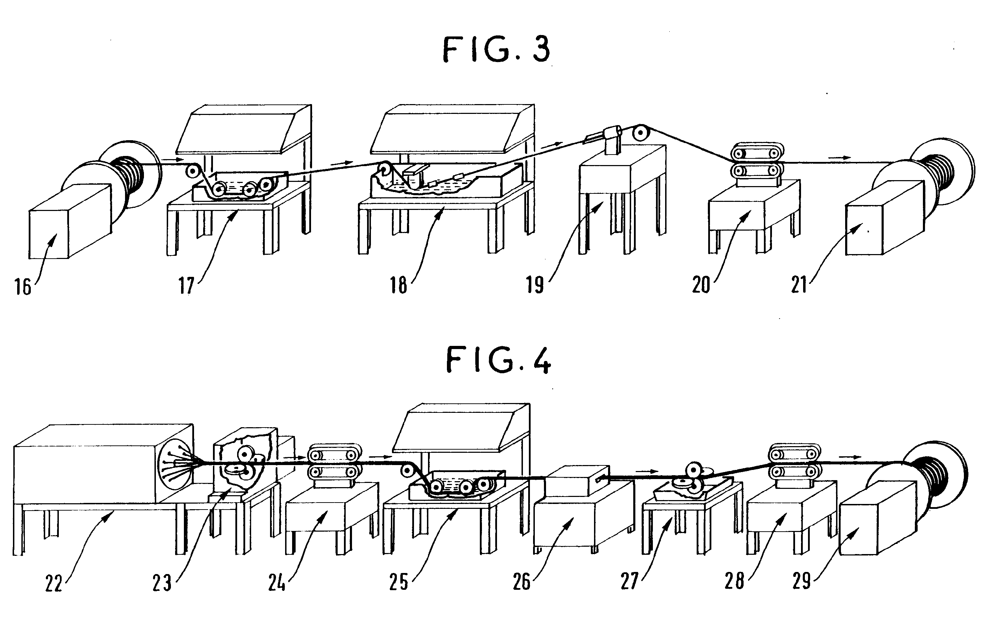

La figure 3 représente la ligne d'étamage des brins individuels.

Le brin supraconducteur issu d'un dérouleur 16 passe dans un bac de décapage 17, puis dans un bain d'étamage 18, où il se recouvre d'une couche d'étain de quelques micromètres. Il passe de là dans un poste de refroidissement 19 puis, tiré par un poste de traction 20, est envoyé à un touret de conditionnement 21.

Dans la figure 4, les brins supraconducteurs étamés et non étamés issus d'un tourniquet 22, passent dans un organe d'assemblage avec transposition appelé "tête de Turc" 23. Le conducteur supraconducteur formé, tiré par un poste de traction 24, se rend au bain de décapage 25. A la sortie de ce bain, il traverse le four 26 dans lequel il est chauffé à une température supérieure à la température de fusion de l'étain, ce qui amène l'étain des brins étamés à diffuser partiellement vers les brins étamés et non étamés adjacents et dans les interstices entre brins. A la sortie du four, le supraconducteur passe dans une "tête de Turc" de calibrage et de refroidissement 27, puis, tiré par un poste de traction 28, se rend au touret de conditionnement 29.

## Revendications

1. Conducteur supraconducteur à brins multiples transposés avec canaux internes de refroidissement, caractérisé en se qu'il se compose d'une première fraction de brins étamés (1, 3, 5, 7, 9, etc...) et d'une fraction complémentaire de brins non étamés (2, 4, 6, 8, 10, etc...), les brins de la première fraction et de la fraction complémentaire étant régulièrement alternés, dans lequel leur assemblage avec transposition est assuré par des adhérences sensiblement ponctuelles entre les brins étamés, laissant ainsi subsister à l'intérieur du conducteur supraconducteur des canaux (11, 12, etc...) pour la circulation d'un fluide réfrigérant.

2. Conducteur supraconducteur selon la revendication 1, caractérisé en ce que la moitié des brins est étamée.

3. Procédé de fabrication d'un conducteur supraconducteur selon les revendications 1 ou 2, caractérisé en ce que l'on étame individuellement (18) une fraction des brins destinés à former le conducteur supraconducteur, en ce que l'on assemble avec transposition (22, 23) les brins étamés et les brins non étamés en une structure où ils sont régulièrement alternés, en ce que l'on soumet la structure ainsi formée à un chauffage (26) assurant la fusion de la couche d'étain des brins étamés, puis en ce que l'on laisse l'ensemble faire prise par refroidissement (27) en une structure munie de canaux (11, 12) délimités par des brins préalablement étamés et des brins non préalablement étamés.

4. Procédé selon la revendication 3, caractérisé en ce que l'on étame la première fraction des brins de manière qu'ils soient recouverts d'une couche d'étain de quelques micromètres.

## Patentansprüche

1. Supraleiter mit zahlreichen transponierten Adern und inneren Kühlkanälen, dadurch gekennzeichnet, daß er zu einem Teil aus verzinnten Adern (1, 3, 5, 7, 9 usw.) und zu einem komplementären Teil aus nicht verzinnten Adern (2, 4, 6, 8, 10 usw.) besteht, wobei sich die Adern des ersten Teils und des komplementären zweiten Teils regelmäßig abwechseln und wobei ihr transponierter Zusammenbau durch im wesentlichen punktförmige Haftstellen zwischen den verzinnten Adern gewährleistet ist und im Inneren des Supraleiters Kanäle (11, 12 usw.) zum Umlauf eines Kühlfluids verbleiben.

2. Supraleiter nach Anspruch 1, dadurch gekennzeichnet, daß die Hälfte der Adern verzinnt ist.

3. Verfahren zur Herstellung eines Supraleiters nach Anspruch 1 oder 2, dadurch gekennzeichnet, daß man einzeln (18) einen Teil der zur Bildung des Supraleiters vorgesehenen Adern verzinnt, daß man die verzinnten und die nicht verzinnten Adern transponiert in einer Struktur zusammenbaut, in der sie sich regelmäßig abwechseln, daß die so gebildete Struktur erwärmt wird (26), so daß die Zinnschicht der verzinnten Adern schmilzt, daß man dann das Ganze durch Kühlung (27) sich in einer Struktur verfestigen läßt, die Kanäle (11, 12) zwischen den vorher verzinnten und den vorher nicht verzinnten Adern aufweisen.

4. Verfahren nach Anspruch 3, dadurch gekennzeichnet, daß man den ersten Teil der Adern so verzinnt, daß sie mit einer Zinnschicht von einigen Mikrometern bedeckt sind.

## Claims

1. A superconducting conductor having multiple transposed strands with internal cooling channels, the conductor being characterized in that it comprises a first fraction of tinned strands (1, 3, 5, 7, 9, etc. ...) and an additional fraction of non-tinned strands (2, 4, 6, 8, 10, etc. ...), the strands of the first fraction and of the additional fraction alternating regularly in which the assembly with transposition is provided by substantially point adherence between the tinned strands thus leaving channels (11, 12, etc. ...) inside the superconducting conductor for cooling liquid circulation.

2. A superconducting conductor according to claim 1, characterized in that one half of the strands are tinned.

3. A method of manufacturing a superconducting conductor according to claim 1 or 2, characterized in that a fraction of the strands for constituting the superconducting conductor are individually tinned (18), in that the tinned strands are assembled with transposition (22, 23) with the non-tinned strands in a structure where they alternate regularly, in that the structure formed in this way is subjected to heating causing the layer of tin on the tinned strands to melt, and then in that the assembly is allowed to set by cooling (27) into a structure provided with channels (11, 12) delimited by the prior-tinned strands and by the non-prior-tinned strands.

4. A method according to claim 3, characterized in that the first fraction of strands is tinned in such a manner as to cover them with a layer of tin which is a few micrometers thick.
